# EUROPEAN PATENT APPLICATION

(11) **EP 4 219 787 A1**
(43) Date of publication of application: **02.08.2023**
(21) Application number: 22305098.0
(22) Date of filing: 28.01.2022
(51) Int. Cl.: C23C 14/24, C23C 14/26

(54) **PHYSICAL VAPOR DEPOSITION MACHINE WITH A THERMAL EVAPORATOR HAVING A CUP HEATED-UP BY ELECTRIC CURRENT**

(71) Applicant: Essilor International, 94220 Charenton-Le-Pont (FR)
(72) Inventor: BEINAT, Olivier, 78810 Thomery (FR)
(74) Representative: Ipsilon

(57) **Abstract**

The invention concerns a physical vapor deposition machine for depositing a coating onto at least one article, comprising:
- an article support member disposed within a chamber and configured to receive a plurality of articles disposed thereto to be coated,
- at least one thermal evaporator in said chamber and configured to generate a flow of vaporized material to coat said plurality of articles with said flow of vaporized material,
wherein said at least one thermal evaporator comprises:
• two electrical electrodes each electrically connected to an electrical generator,
• a cup for receiving material to be vaporized, said cup being formed by an electrically conductive material and configured to be in electrical contact with each of said two electrical electrodes to form an electrical circuit, said generator being configured to provide a current through said electrical circuit able to heat-up said cup so as to vaporize said material received into said cup.

## Description

The invention concerns a physical vapor deposition machine. Particularly, the invention concerns a physical vapor deposition machine for depositing a coating onto at least one article, for example an ophthalmic lens. The invention further concerns a method for physical vapor deposition using such physical vapor deposition machine.

Layer deposition is a process applied in many industries to form coating so as to protect surfaces and/or to impart a variety of desired properties to said surfaces. For example, in optics, an antireflective or anti-reflection (AR) coating is a type of optical coating applied to the surface of lenses or other optical devices to reduce reflection.

A vapor deposition machine also comprises a thermal evaporator to provide a coating to the articles, especially a topcoat. The thermal evaporator allows to heat up a material to obtain a flow of vaporized material. This flow of vaporized material is deposited onto the article to form a coating thereto.

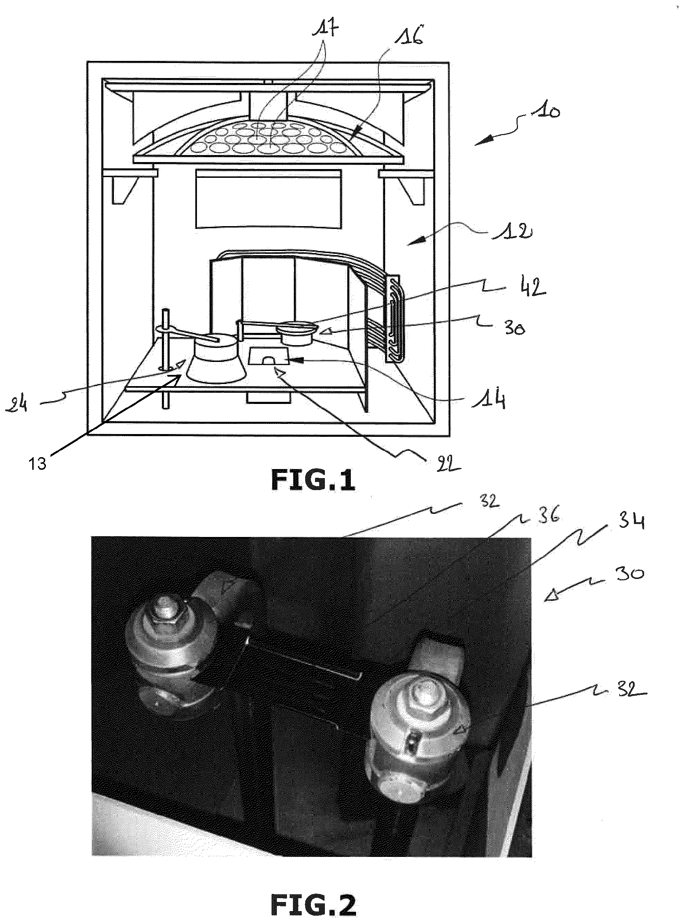

Such a thermal evaporator is part of a vapor deposition machine 10 as shown on figure 1. The physical vapor deposition machine 10 comprises a chamber 12 which can be selectively put under vacuum. The physical vapor deposition machine 10 comprises a thermal evaporator 30 within the chamber 12. The vapor deposition machine 10 may also comprise an electron beam gun 22 associated to a crucible assembly 14 and an ion gun 24.

The physical vapor deposition machine 10 also comprises an article support member 16 configured to receive a plurality of articles 17 to be coated by a flow of vaporized material or reached by a flow of ions from the thermal evaporator 30, the electron beam gun 22 and/or the ion gun 24.

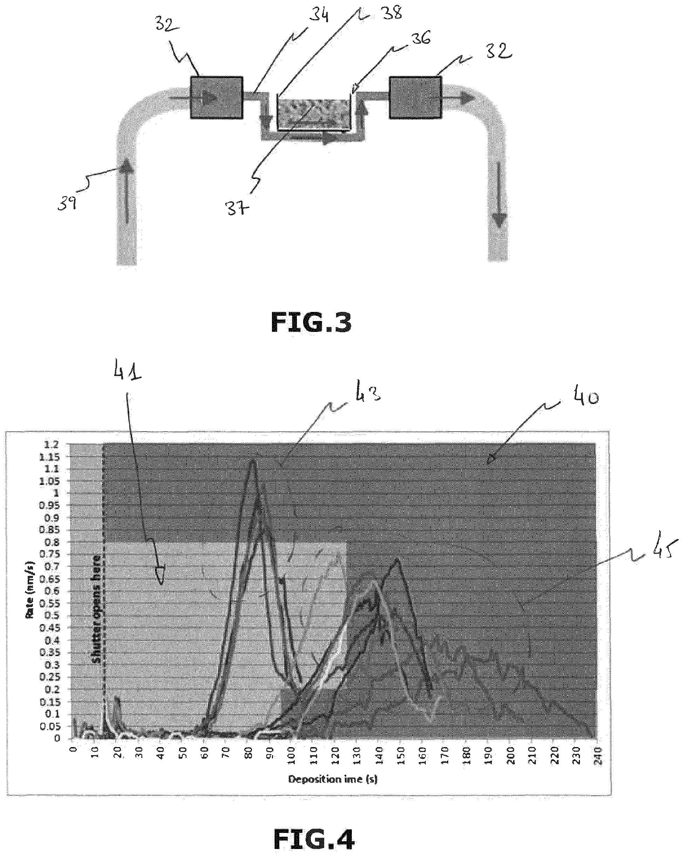

An example of a known or conventional thermal evaporator 30 is shown on figures 2 and 3.

This known thermal evaporator 30 comprises two electrical electrodes 32 each electrically connected to an electrical generator (not shown). A plate 34 is disposed between the two electrical electrodes 32 and electrically connected thereto. This plate 34, also called "boat", is generally made of tantalum to conduct both electricity and heat. Plate 34 is fixed to the electrical electrodes 32 so that an electrical circuit is formed between the electrical electrodes 32 with the current flowing through the plate 34. Plate 34 defines a cavity 36 for receiving a receptacle.

The thermal evaporator 30 also comprises a cup 38 receiving material 37 to be vaporized. Before operating the thermal evaporator 30, said cup 38 is filled with material to be vaporized and then disposed within the cavity 36. When the thermal evaporator is activated, the whole electrical current flows through the two electrodes 32 and the plate 34 so that said plate 34 is warmed-up by joule effect. The cup 38 which is in contact with the plate 34 is warmed-up by the plate 34 by thermal conduction. When the cup 38 reaches a vaporization temperature, material within the cup 38 is vaporized and deposited onto the articles disposed above the thermal evaporator 30. Electrical current flow is symbolized by arrows 39.

Figure 4 shows a graph of several experiments using the known thermal evaporator 30 to deposit a coating onto an article. Each curve corresponds to a coating deposition sequence and is represented by the deposition rate of material vaporized by the thermal evaporator over time. The same coating deposition sequence is performed for each experiment with similar materials used for depositing a topcoat onto the articles.

An operating area 41 is defined wherein it is desirable to operate the thermal evaporator 30. In the example of figure 4, the thermal evaporator 30 is operated with a maximal deposition rate of 0,8nm/s up to 95s and between 0,2nm/s and 0,8nm/s from 95s to 125s. Shaded area 40 represents an area wherein it is not desirable to operate.

A shutter 42 of the thermal evaporator 30 is disposed between the thermal evaporator 30 and the articles to prevent any vaporized material to flow through the articles 17. The shutter 42 is put in place at the beginning of the sequence and up to 15sec. The shutter 42 is then opened to allow the vaporized material to reach the articles 17.

It can be seen on figure 4 that material evaporation starts within approximately 50s after the opening of the shutter 42 for a first set of curves 43. Material evaporation then starts within approximately 80s for a second set of curves 45. Furthermore, it can be observed that evaporation of the material took place in a very different way with important dispersion for each experiment showing up that the process is not reliably repeatable. The profile of the deposition rate thus seems to highly vary depending on the installation of the thermal evaporator 30, especially the cup 36 which is displaced to be filled with material for each new experiment.

Furthermore, it can be seen that most part of the evaporation took place in the shaded area 40 wherein operation is not desirable.

Figure 4 thus highlights that the deposition rate of material using the known thermal evaporator 30 is not controlled in a satisfactory way with an important dispersion, a fortiori not in a repeatable way.

There is a need for an improved physical vapor deposition machine allowing the material to be warmed-up more quickly and a better control of the deposition rate, while making the deposition sequence more reliably repeatable.

To solve this problem, the invention provides a physical vapor deposition machine for depositing a coating onto at least one article, comprising:
- a chamber,
- an article support member disposed within said chamber and configured to receive a plurality of articles disposed thereto to be coated,
- at least one thermal evaporator disposed within said chamber and configured to generate a flow of vaporized material to coat said plurality of articles with said flow of vaporized material,
   wherein said at least one thermal evaporator comprises:
   - two electrical electrodes each electrically connected to an electrical generator,
   - a cup for receiving material to be vaporized, said cup being formed by an electrically conductive material and configured to be in electrical contact with each of said two electrical electrodes to form an electrical circuit, said generator being configured to provide a current through said electrical circuit able to heat-up said cup so as to vaporize said material received into said cup.

In this thermal evaporator, the cup is in contact with the two electrical electrodes to form and close an electrical circuit including the electrical generator, the two electrical electrodes and the cup. In doing so, electrical current from the electrical generator flows directly from one electrical electrode to another through the cup. The cup is thus warmed-up by joule effect due to the electrical current flow instead of thermal conduction in the known thermal evaporators. The whole electrical current flows here through the cup because the only part contacting the two electrical electrodes is the cup.

This direct warming-up of the cup by joule effect allows to improve warming-up of the material received therein and so is the evaporation of this material. Indeed, material is warmed-up much more quickly with this direct heating (joule effect) so that evaporation appears much earlier than with a conventional thermal evaporator. Particularly, evaporation starts within 10s after the opening the shutter whereas the known thermal evaporator starts within 50s. The evaporation process is thus much more reactive.

This improved reactivity of the evaporation allows to better control the deposition rate such that the profile of the deposition rate over time can be easily monitored to prevent it to go into the non-operating area (i.e. shaded area 40 of figure 4).

It has also been observed that this direct heating of the cup allows the evaporation rate profile over time to be reliably repetitive with much lower dispersion than with the known thermal evaporators.

According to an embodiment of the physical vapor deposition machine, a gap is formed between said two electrical electrodes, said cup being configured to be disposed within said gap to electrically close said electrical circuit to allow current to flow from an electrode to the other electrode through said cup.

According to an embodiment of the physical vapor deposition machine, the cup is removably connected to said two electrodes.

According to an embodiment of the physical vapor deposition machine, said at least one thermal evaporator comprises a positioning arrangement between at least one of the two electrical electrodes and the cup.

According to an embodiment of the physical vapor deposition machine, said positioning arrangement is configured to contact said cup at a lateral portion of said cup.

According to an embodiment of the physical vapor deposition machine, said positioning arrangement is formed by an electrically conductive material so that said positioning arrangement is part of said electrical circuit.

According to an embodiment of the physical vapor deposition machine, said positioning arrangement comprises at least one positioning imprint formed by at least one of said two electrical electrodes to contact said cup at at least three different contact points.

According to an embodiment of the physical vapor deposition machine, the at least one positioning imprint comprises a V-shaped portion for contacting a lateral portion of said cup at at least two contact points.

According to an embodiment of the physical vapor deposition machine, the positioning arrangement further comprise a bottom wall for supporting a bottom portion of said cup when said cup is disposed within the at least one positioning imprint.

According to an embodiment of the physical vapor deposition machine, said positioning arrangement comprises a first and a second parts, at least one among said first and second parts is movable from a release position wherein said cup is unlocked and free to be removed to a locked position wherein said cup is locked in an operating position wherein said cup electrically closes the electrical circuit.

According to an embodiment of the physical vapor deposition machine, a positioning axis is defined by the alignment between said cup and said two electrical electrodes, said at least one among said first and second parts being movable along a locking axis perpendicular to said positioning axis, said at least one among said first and second parts having a biased surface configured to contact said cup in the operating position.

According to an embodiment of the physical vapor deposition machine, said two electrical electrodes are a first and a second electrical electrodes, said first part being disposed between the first electrical electrode and the cup, said second part being disposed between the second electrical electrode and the cup, said cup electrically closing said electrical circuit when contacting each of said first and second parts.

The invention further provides a method for depositing a coating onto at least one article using a physical vapor deposition machine which comprises:
- a chamber,
- an article support member disposed within said chamber and configured to receive a plurality of articles disposed thereto to be coated,
- at least one thermal evaporator disposed within said chamber and configured to generate a flow of vaporized material to coat said plurality of articles with said flow of vaporized material,
   wherein said at least one thermal evaporator comprises:
   - two electrical electrodes each electrically connected to an electrical generator,
   - a cup for receiving material to be vaporized, said cup being formed by an electrically conductive material and configured to be in electrical contact with each of said two electrical electrodes to form an electrical circuit, said generator being configured to provide a current through said electrical circuit able to heat-up said cup so as to vaporize said material received into said cup,
      said method comprising the following steps:
      - disposing at least one article onto said article support member,
      - providing said cup with material to be vaporized,
      - disposing said cup between and in contact with said two electrical electrodes,
         providing a current through said electrical circuit to heat-up said cup so as to vaporize said material received into said cup and deposit a coating onto said at least one article.

Figure 1 shows a machine for physical vapor deposition comprising a vacuum container, an article support member having articles to be coated and a thermal evaporator.

Figure 2 shows a perspective view of a known thermal evaporator having a tantalum plate to receive a cup of material.

Figure 3 schematically shows a side view of the known evaporator of figure 2.

Figure 4 shows a graph of the deposition rate profiles of a plurality of experiments using the known thermal evaporator of figures 2 and 3.

Figure 5 schematically shows a side view of a thermal evaporator according to the invention with a cup directly contacting electrical electrodes to warm-up material disposed therein.

Figure 6 shows a graph of the deposition rate profiles of a plurality of experiments using the thermal evaporator of figure 5.

Figures 7 and 8 show perspective side and top views of an example of thermal evaporator according to the invention.

In the description which follows, the drawing figures are not necessarily to scale and certain features may be shown in generalized or schematic form in the interest of clarity and conciseness or for informational purposes. In addition, although making and using various embodiments are discussed in detail below, it should be appreciated that as described herein are provided many inventive concepts that may embodied in a wide variety of contexts. Embodiments discussed herein are merely representative and do not limit the scope of the invention. It will also be obvious to one skilled in the art that all the technical features that are defined relative to a process can be transposed, individually or in combination, to a device and conversely, all the technical features relative to a device can be transposed, individually or in combination, to a process.

The terms "comprise" (and any grammatical variation thereof, such as "comprises" and "comprising"), "have" (and any grammatical variation thereof, such as "has" and "having"), "contain" (and any grammatical variation thereof, such as "contains" and "containing"), and "include" (and any grammatical variation thereof such as "includes" and "including") are open-ended linking verbs. They are used to specify the presence of stated features, integers, steps or components or groups thereof, but do not preclude the presence or addition of one or more other features, integers, steps or components or groups thereof. As a result, a method, or a step in a method, that "comprises", "has", "contains", or "includes" one or more steps or elements possesses those one or more steps or elements but is not limited to possessing only those one or more steps or elements.

The present invention provides a physical vapor deposition machine for depositing a coating onto an article. An example of such a physical vapor deposition machine 10 is shown on figure 1.

The physical vapor deposition machine 10 comprises a chamber 12 which can be selectively put under vacuum. The physical vapor deposition machine 10 also comprises an article support member 16 disposed within said chamber 12 and configured to receive a plurality of articles 17 disposed thereto to be coated. The chamber 12 comprises a base surface 13 onto which material to be vaporized may be disposed.

The articles 17 are disposed onto a receiving surface 19 of the article support member 16 which faces the base surface 13. The article support member 16 is preferably concave so as to direct all the articles 17 towards the base surface 13. The article support member may be a carrousel. In this case, the article support member 16 may be bell-shaped with the articles 17 disposed onto an inner surface of this bell. Alternatively, the article support member 16 may be a drum. In this case, the thermal evaporator 50 may disposed at the center thereof.

In a preferred embodiment, the articles 17 are ophthalmic lenses.

Said physical vapor deposition machine 10 also comprises at least one thermal evaporator 50 disposed within said chamber 12. The at least one thermal evaporator 50 is configured to generate a flow of vaporized material to coat said plurality of articles 17 with said flow of vaporized material.

The thermal evaporator 50 is configured to heat-up up to evaporation a material to obtain a flow of vaporized material. This flow of vaporized material obtained with the thermal evaporator 50 may provide a coating onto the articles 17. This coating may be a topcoat.

Said physical vapor deposition machine 10 may also comprise a shutter 42 of the thermal evaporator 50. Said shutter 42 is configured to be disposed between the thermal evaporator 50 and the articles 17 to prevent any vaporized material to flow through the articles 17.

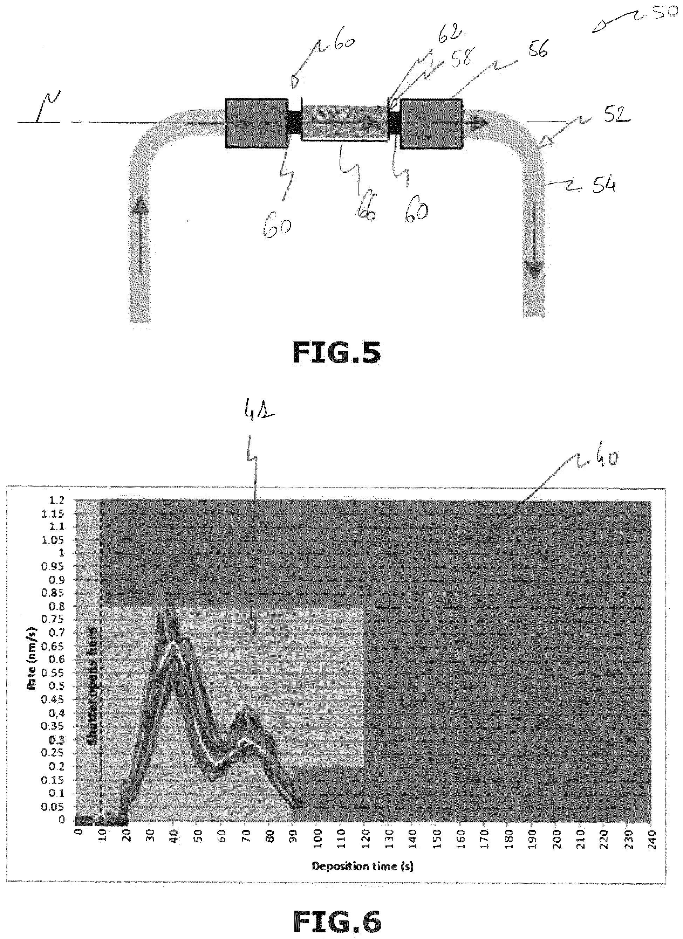

As shown on figure 5, said thermal evaporator 50 comprises two electrical electrodes 52 each electrically connected to an electrical generator (not shown). The electrical generator may provide to the electrical electrodes electrical current at least up to 90A. Each electrical electrode 52 comprises a stem 54 having at the end fastening means 56. Said fastening means 56 may comprise at least one removable or movable part allowing a connecting part to be fixed to the electrical electrode 52. Both the stem 54 and the fastening means 56 are made of electrically conductive material, preferably from copper or a copper alloy.

The electrical electrodes 52 are facing each other with a gap 60 therebetween. Hence, the electrical electrodes 52 do not contact each other when no part is disposed within this gap 60. Electrical current thus cannot flow from an electrical electrode 52 to the other electrical electrode 52 when the gap 60 is free from an electrically conductive part. In other words, the electrical circuit formed by the electrical generator and the two electrical electrodes 52 is electrically opened when the gap 60 is free from an electrically conductive part.

The thermal evaporator 50 further comprises a cup 58 for receiving material to be vaporized. Said cup 58 is formed by an electrically conductive material, as copper. Said cup is also preferably formed by a thermally conductive material.

According to an embodiment, said material to be vaporized is in direct contact with said cup 58. The material may be liquid and poured in the cup 58.

The material to be vaporized may be impregnated in a support, this support being put in contact with the cup. The support may be:
- a block of metal fibers or thin metal wires impregnated with the material, or
- a porous ceramic impregnated with the material.

The porous ceramic is preferably formed into a pellet from the aspect of the easiness of handling. The metal fibers or thin metal wires may be made of iron, platinum, silver, copper, etc. In an embodiment, the metal fibers or the thin metal wires are tangled such that they can retain a sufficient amount of material, preferably a hydrophobic material. The metal fibers or the thin metal wires may be woven or nonwoven. The block of metal fibers or thin metal wires may have such a porosity that can be determined depending on how much the hydrophobic, reactive organic compound is retained.

Said cup 58 is also configured to be in electrical contact with each of said two electrical electrodes 52 to form an electrical circuit. Hence, when the cup 58 is disposed in contact with each of the two electrical electrodes 52, electrical current flows from an electrical electrode to another through the cup 58. Said cup 58 is warmed-up by joule effect when electrical current flows through said electrical circuit so that material within the cup 58 is also warmed-up. Evaporation then occurs when the material temperature reaches an evaporation temperature threshold. This evaporation temperature threshold may be reached by providing the electrical electrodes with an electrical current of 90A.

The whole electrical current flows here through the cup because the only part contacting the two electrical electrodes 52 is the cup 58.

Different experiments were performed using this thermal evaporator 50 to observe the deposition rate over time as well as the repeatability of the process. Figure 6 shows a graph wherein each curve corresponds to such an experiment to show deposition rate over time.

As in figure 4, the deposition sequence or process starts with the shutter 42 in a closed position. The electrical generator is turned on with the shutter in the closed position for 10s. The shutter 42 is then opened to let the vaporized material reach the articles 17. This step of the process wherein the shutter 42 is in the closed position and opened after a predetermined period is optional.

It can be observed from figure 6 that evaporation occurs very quickly for each curve, approximately within 10s after the opening of the shutter 42. Warming-up of the material is thus much more reactive (10s) with the thermal evaporator 50 than with the conventional thermal evaporator 10 (50s).

This improved reactivity of the evaporation allows to better control the deposition rate of the coating on the articles 17. This makes the control loop more efficient because there is less thermal inertia with the thermal evaporator 50 than with the conventional evaporator 10. It is thus easier to keep the deposition rate within the operating area 41.

Furthermore, all the curves follow a same profile with less dispersion showing-up that the deposition rate behaved very similarly for each experiment. The deposition rate thus appears to be very repeatable with this thermal evaporator 50.

Said cup 58 is preferably removably connected to said two electrical electrodes 52. Hence, it is possible to remove the cup 58 from the two electrical electrodes 52 to fill it with some new material for each deposition process. Filling-up the material within the cup 58 is more practical and easier.

The thermal evaporator 50 preferably comprises a positioning arrangement 60 between at least one of the two electrical electrodes 52 and the cup 58. This positioning arrangement 60 forms an interface between at least one of the two electrical electrodes 52 and the cup 58 to ease positioning the cup 58. This positioning arrangement 60 is configured to position the cup 58 at an operating position wherein the cup 58 has an electrical contact with each of the two electrical electrodes 52.

Said positioning arrangement 60 may also be configured to secure the cup 58 in the operating position.

Said positioning arrangement 60 is preferably formed by an electrically conductive material so that said positioning arrangement 60 is part of the electrical circuit.

Said positioning arrangement 60 is preferably fixed to at least one electrical electrode 52. Particularly, the positioning arrangement is fixed to a fastening means 56 of said electrical electrode 52.

Said positioning arrangement may be configured to contact said cup 58 at a lateral portion 62 of said cup 58. In other words, the positioning arrangement 60 contacts the lateral portion of the cup 58 when the electrical circuit is closed. Said positioning arrangement 60 may also comprise a bottom wall 64 for supporting a bottom portion 66 of said cup 58.

Said positioning arrangement 60 may comprise at least one positioning imprint 68 formed by at least one of said two electrical electrodes 52 to contact said cup at at least three different contact points or lines. In doing so, the cup 58 is positioned in a stable manner. Said positioning imprint 68 may be positioned between one electrical electrode 52 and the cup 58. Alternatively, said positioning arrangement 60 may comprise at least two positioning imprints 68, a first positioning imprint 68 between a first electrical electrode 52 and the cup 58 and a second positioning imprint 68 between a second electrical electrode 52 and the cup 58.

Said positioning imprint 68 may comprise a V-shaped portion for contacting the lateral portion 62 of said cup 58 at at least two contact points.

Said positioning imprint 68 may comprise a planar or linear portion for contacting the lateral portion 62 of said cup 58.

Said planar or linear portion and V-shaped portion may be used for contacting opposite areas of the lateral portion 62 of the cup 58 to provide three contact points or lines.

A contact point or line may refer to a local surface surrounding a point or a line, notably due to manufacturing geometrical constraints.

In a preferred embodiment, said positioning arrangement 60 comprises a first and a second parts. At least one among said first and second parts is movable from a release position to a locked position. In said release position, said cup 58 is unlocked and free to be removed. In said locked position, said cup 58 is locked in an operating position wherein said cup 58 electrically closes the electrical circuit.

Said at least one among said first and second parts is preferably movable along a locking axis perpendicular to a positioning axis A defined by the alignment between said cup 58 and said two electrical electrodes 52, as shown on figure 5. The movable part preferably has a biased surface configured to contact said cup 58 in the operating position so that locking and unlocking of the cup is obtained with the translation of the biased surface. The biased surface is biased relative to the locking axis.

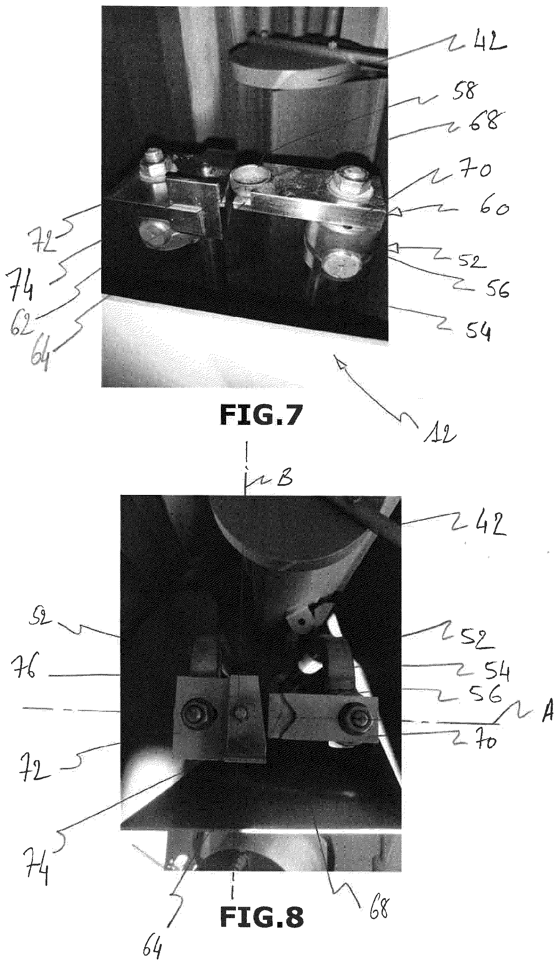

A preferred embodiment is shown on figures 7 and 8 wherein the positioning arrangement 60 comprises a first part 70 removably connected to a first electrical electrode 52. This first part 70 comprises a positioning imprint 68 having a V-shaped portion and a bottom wall 64 for respectively contacting the lateral portion 62 and the bottom portion 66 of the cup 58. When the cup 58 is filled with material, it can be lodged within the positioning imprint 68. The bottom wall 64 is configured to have a surface at least equal to half the bottom portion 66 of the cup 58 to allow the cup 58 to rest on the bottom wall 64 without any other contact.

The positioning arrangement 60 also comprises a second part 72 removably connected to a second electrical electrode 52. This second part 72 comprises a movable portion 74 having a biased surface 76 configured to be moved from a release position to a locked position. This movable portion 74 is movable along a locking axis B perpendicular to the positioning axis A. The second part 72 may comprise a return spring (not shown) configured to return the movable portion 74 from the release position to the locked position and apply a predetermined effort to secure the cup 58 into the operating position. The biased surface 76 along with the return spring allows the electrical connection between the electrical electrodes 52 and the cup 58 to be more reliable.

Placing the cup 58 in the operating position starts with moving the movable portion 74 to the release position, disposing the cup 58 within the positioning imprint 68 and then returning the movable portion 74 to the locked position. The cup 58 is hence pressed between the first 70 and the second 72 parts thanks to the biased surface 76 and the return spring.

In addition to the at least thermal evaporator 50, said physical vapor deposition machine 10 may comprise a crucible assembly 14 disposed within the chamber 12 as well as a thermal evaporator 50, an electron beam gun 22 and an ion gun 24.

The electron beam gun 22 is configured to vaporize material received into the crucible assembly 14 to provide a flow of vaporized material. This flow of vaporized material obtained with the electron beam gun 52 may provide a coating onto the articles 17. This coating may be an anti-reflective layer.

The ion gun 54 is configured to provide a flow of ions towards the articles 17. This flow of ions may be used for densification of a layer or for activating a surface of a substrate before depositing a coating.

The crucible assembly 14, the thermal evaporator 50, the electron beam gun 52 and the ion gun 54 are disposed at the base surface 13.

## Claims

1. A physical vapor deposition machine (10) for depositing a coating onto at least one article (17), comprising:
- a chamber (12),
- an article support member (16) disposed within said chamber (12) and configured to receive a plurality of articles (17) disposed thereto to be coated,
- at least one thermal evaporator (50) disposed within said chamber and configured to generate a flow of vaporized material to coat said plurality of articles with said flow of vaporized material,
wherein said at least one thermal evaporator (50) comprises:
• two electrical electrodes (52) each electrically connected to an electrical generator,
• a cup (58) for receiving material to be vaporized, said cup being formed by an electrically conductive material and configured to be in electrical contact with each of said two electrical electrodes (52) to form an electrical circuit, said generator being configured to provide a current through said electrical circuit able to heat-up said cup (58) so as to vaporize said material received into said cup (58).

2. The physical vapor deposition machine according to claim 1, wherein a gap (60) is formed between said two electrical electrodes (52), said cup being configured to be disposed within said gap to electrically close said electrical circuit to allow current to flow from an electrode to the other electrode through said cup (58).

3. The physical vapor deposition machine according to claim 1 or 2, wherein the cup (58) is removably connected to said two electrodes.

4. The physical vapor deposition machine according to one of claims 1 to 3, wherein said at least one thermal evaporator (50) comprises a positioning arrangement (60) between at least one of the two electrical electrodes and the cup.

5. The physical vapor deposition machine according to claim 4; wherein said positioning arrangement (60) is configured to contact said cup at a lateral portion (62) of said cup (58).

6. The physical vapor deposition machine according to claim 4 or 5, wherein said positioning arrangement (60) is formed by an electrically conductive material so that said positioning arrangement (60) is part of said electrical circuit.

7. The physical vapor deposition machine according to any one of claims 4 to 6, wherein said positioning arrangement (60) comprises at least one positioning imprint (68) formed by at least one of said two electrical electrodes (52) to contact said cup at at least three different contact areas.

8. The physical vapor deposition machine according to claim 7, wherein the at least one positioning imprint comprises a V-shaped portion for contacting a lateral portion of said cup at at least two different contact areas.

9. The physical vapor deposition machine according to claim 7 or 8, wherein the positioning arrangement (60) further comprise a bottom wall (64) for supporting a bottom portion (66) of said cup when said cup is disposed within the at least one positioning imprint.

10. The physical vapor deposition machine according to any one of claims 4 to 9, wherein said positioning arrangement (60) comprises a first (70) and a second (72) parts, at least one among said first and second parts is movable from a release position wherein said cup is unlocked and free to be removed to a locked position wherein said cup is locked in an operating position wherein said cup electrically closes the electrical circuit.

11. The physical vapor deposition machine according to claim 10, wherein a positioning axis (A) is defined by the alignment between said cup and said two electrical electrodes (52), said at least one among said first (70) and second (72) parts being movable along a locking axis (B) perpendicular to said positioning axis, said at least one among said first and second parts having a biased surface configured to contact said cup in the operating position.

12. The physical vapor deposition machine according to claim 10 or 11, wherein said two electrical electrodes (52) are a first and a second electrical electrodes, said first part being disposed between the first electrical electrode (52) and the cup (58), said second part being disposed between the second electrical electrode and the cup, said cup electrically closing said electrical circuit when contacting each of said first and second parts.

13. A method for depositing a coating onto at least one article using a physical vapor deposition machine (10) which comprises:
- a chamber (12),
- an article support member (16) disposed within said chamber and configured to receive a plurality of articles disposed thereto to be coated,
- at least one thermal evaporator (50) disposed within said chamber and configured to generate a flow of vaporized material to coat said plurality of articles with said flow of vaporized material,
wherein said at least one thermal evaporator comprises:
• two electrical electrodes (52) each electrically connected to an electrical generator,
• a cup (58) for receiving material to be vaporized, said cup being formed by an electrically conductive material and configured to be in electrical contact with each of said two electrical electrodes to form an electrical circuit, said generator being configured to provide a current through said electrical circuit able to heat-up said cup so as to vaporize said material received into said cup,
said method comprising the following steps:
• disposing at least one article onto said article support member,
• providing said cup with material to be vaporized,
• disposing said cup between and in contact with said two electrical electrodes,
• providing a current through said electrical circuit to heat-up said cup so as to vaporize said material received into said cup and deposit a coating onto said at least one article.
